# EUROPEAN PATENT APPLICATION

(11) **EP 2 105 962 A2**
(43) Date of publication of application: **30.09.2009**
(21) Application number: 09153238.2
(22) Date of filing: 19.02.2009
(51) Int. Cl.: H01L 27/12, H01L 21/84

(54) **Semiconductor device and production method thereof**

(30) Priority: 27.03.2008 JP 2008082356
(71) Applicant: Hitachi Ltd., Chiyoda-ku Tokyo (JP)
(72) Inventor: Watanabe, Atsuo c/oHitachi, Ltd., Int. Property Group, 12th Floor,, Chiyoda-ku,Tokyo 100-8220 (JP); Honda, Mitsutoshi c/o Hitachi, Ltd., Int. Prop. Group, 12th Floor,, Chiyoda-ku, Tokyo 100-8220 (JP)
(74) Representative: Borchert, Uwe Rudolf

(57) **Abstract**

The side-wall oxide films (105) of a deep isolation trench (100) formed in the active layer of a SOI substrate are extended on the surface of an active layer, and thereby the absolute misalignment of a gate polysilicon is remarkably reduced and fine processing is made possible. The electrode arranged in the neighborhood of the element isolation trench is isolated from the silicon surface by an insulating film (120) at least four times thicker than the oxide films on the trench side walls and thereby to avoid the dielectric breakdown of high dielectric breakdown voltage elements.

## Description

This invention relates to a semiconductor device using a dielectric isolation structure for device insulation and a production method thereof.

A dielectric isolation semiconductor device for controlling a motor has been proposed in which elements are isolated from each other and so are each element and a substrate from each other with a high voltage by surrounding each element with a dielectric material such as a silicon oxide film thereby to integrate a high breakdown voltage element, a large current output circuit and logic circuits of medium and low breakdown voltages.

An example of the conventional high breakdown voltage MOS which is one of the constituent elements of the dielectric isolation semiconductor device described above is disclosed in JP-A-2007-242977 shown in the cross-sectional view of FIG. 9. In FIG. 9, each function region of MOS is formed in a silicon active layer 15 constituting a lightly doped region. In this lightly doped region, function regions including an n⁺-type heavily doped source region 12, a gate electrode 2, a n⁺-type heavily doped drain region 32 and a p-type impurity region region 13 forming a channel. This configuration is shown to include a silicon support substrate 5, a first silicon oxide film 6, second oxide films 105, polysilicon 104 and an n⁺-type heavily doped drain region 9. The lightly doped n-type silicon active layer 15 formed with the MOS is electrically isolated from the surrounding semiconductor regions by the silicon oxide films 6, 105. The polysilicon 201 arranged on the oxide film 50 are formed of the same material as the gate electrode 2 and functions as a wiring.

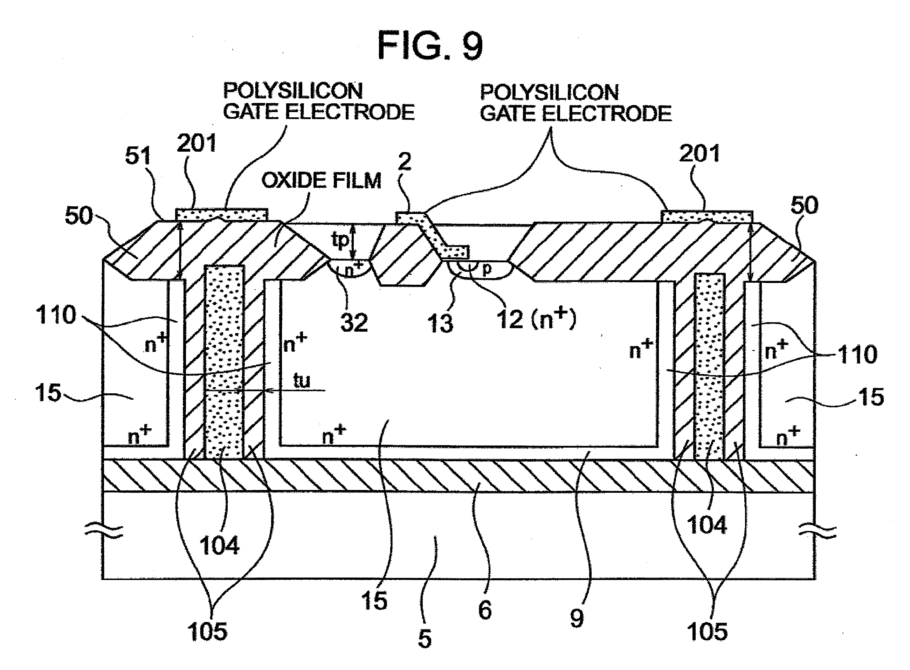

The conventional MOS structure shown in FIG. 9 fails to operate as a high breakdown voltage device unless the oxide film 50 formed under the polysilicon gate electrodes 2 and 201 is sufficiently thickened. This point is described below, The drain region of the high breakdown voltage MOS device is configured of a lightly doped silicon active layer 15 and n⁺-type heavily doped layers 9, 110 surrounding the silicon active layer 15. The n⁺-type heavily doped layers 110 increase to the highest potential of the device in operation. The polysilicon layers 201 arranged above the n⁺-type heavily doped layers 110 through an oxide film, on the other hand, is required to operate at each potential from the ground potential to a high voltage. For this reason, the heavily doped layers 110 making up the drain of the MOS and the polysilicon layers arranged thereon are required to secure the necessary dielectric breakdown voltage against a high voltage which may be applied thereto. The oxide film 50, therefore, is required to have a sufficient thickness. In the case where a rated blocking voltage of the device is 500 V, for example, the film is designed to have a thickness of at least 3 µm to secure the dielectric breakdown voltage of 500 V.

In the case where the oxide film 50 arranged under the polysilicon gate electrode is as thick as several µm, however, the serious disadvantages described below arise. The amount designated as tp in FIG. 9 is defined as a difference in height between the lowest surface and the uppermost surface on which the polysilicon gate electrode is arranged. In the conventional structure shown in FIG. 9, the amount tp substantially coincides with the height difference between the main surface of the silicon and the upper surface 51 of the oxide film 50. In the actual device, the polysilicon gate electrode is mounted through the gate oxide film. Generally, however, the gate oxide film is as thin as 70 nm or less, and this thickness can be ignored as compared to the µm order. Unless otherwise specified in the description that follows, therefore, the thickness of the gate oxide film is ignored as it is not considered to contribute to the dielectric breakdown voltage.

In the high breakdown device of 500 V order, the oxide film is 3 µm or thicker, and therefore, the amount tp represents a step (misalignment) of not less than 1.5 µm, i.e, one half of the oxide film thickness. The amount tp is an important factor to determine the critical dimension in forming the polysilicon gate electrode by photolithography, and in the case where the step is 1.5 µm described above, the minimum gate processing dimension is at most approximately 3 µm.

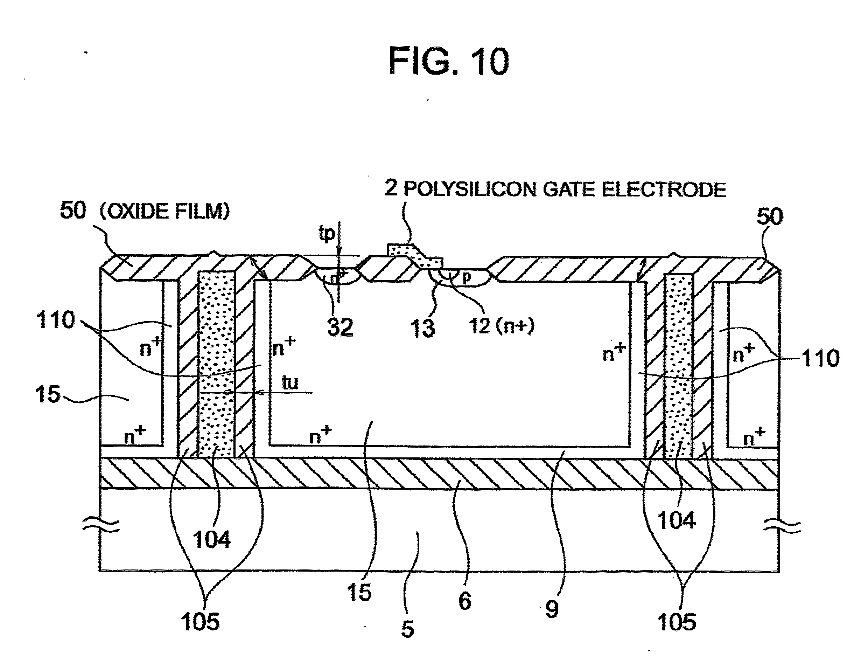

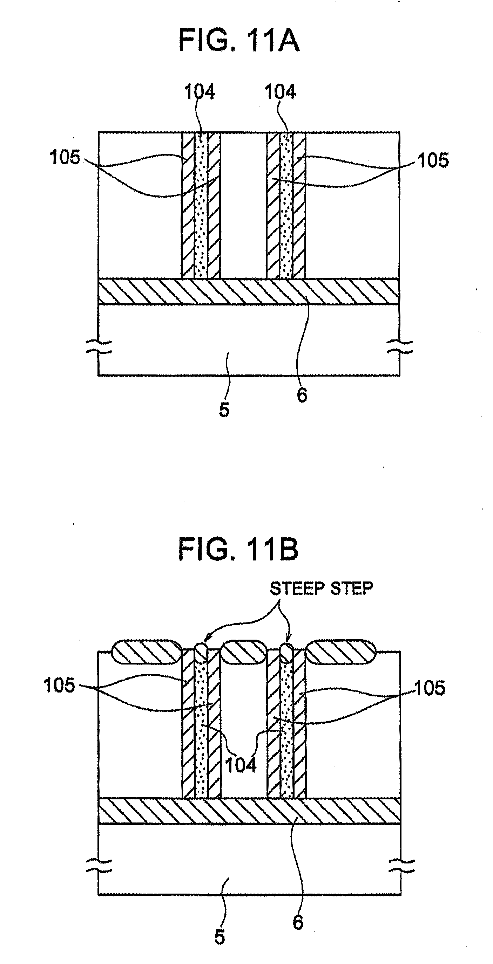

As described above, the conventional structure shown in FIG. 9 has the disadvantage that the oxide film thickness or the amount tp is so large that the minimum value of the silicon gate electrode cannot be reduced. FIG. 10 shows a solution proposed to resolve this disadvantage by reducing the thickness of the oxide film 50 without changing a thickness tu of the oxide film 105 formed on the side surface of each element isolating trench. Nevertheless, this solution harbors a difficult problem which is not sufficiently solved. This point is explained with reference to FIGS. 11A and 11B. FIGS. 11A and 11B show a production method for realizing the configuration shown in FIG. 10. In FIGS.11A and 11B, however, the cross-sectional view of only the neighborhood of the trench is shown. After the isolating trenches are formed as shown in FIG.11A, the surface portion is removed to expose the main silicon surface uniformly. After that, a predetermined surface is oxidized by the local oxidation technique. In the process, the oxidation amount is limited to at most approximately 0.8 µm to secure a small tp value. According to this conventional technique, the side-wall oxide film is exposed above the trenches 100 before the surface oxidation. Therefore, oxidation of the exposed portion is suppressed, and only the silicon surface and the polysilicon film buried in the trenches are oxidized. As shown in FIG. 11B, therefore, a very steep and sharp stepped pattern is formed above the trenches. Due to this sharp stepped pattern above the trenches, the subsequent process executed on the polysilicon gate electrode is unavoidably affected by halation in the photoresist process and an excessive dry etching amount in the subsequent processing of the polysilicon gate electrode. Thus, the fine pattern is lost and the fine gate dimension is adversely affected.

Without solving this problem of a large step formed at the time of processing the polysilicon gate electrode as described above, it is impossible to provide a semiconductor device having both a high breakdown voltage element and a fine MOS device at the same time.

Accordingly, it is an object of this invention to provide a highly reliable dielectric isolation semiconductor device high in breakdown voltage which can coexist with the fine MOS device and a production method thereof.

In order to solve the problems described above, according to a first aspect of the invention, there is provided a semiconductor device using a SOI (Silicon On Insulator) substrate including a semiconductor substrate, a first insulating film formed on one surface of the semiconductor substrate, and a second semiconductor layer having a heavily doped semiconductor layer and a lightly doped semiconductor layer stacked on the first insulating film;
wherein the second semiconductor layer is configured of predetermined regions including an element formed region formed with at least a semiconductor element and an element isolating region surrounding the element formed region;
wherein the element isolating region includes multiple trenches having a laterally closed structure reaching the first insulating film, side-wall oxide films formed in the multiple trenches and polysilicon filled between the side-wall oxide films;
wherein the side-wall oxide films are extended onto one of the main surfaces of the second semiconductor layer and the polysilicon gate electrode is stacked in a predetermined region of the extended area; and
wherein the electrodes of the high breakdown voltage element arranged in the neighborhood of each element isolating trench is isolated from the main surface of the second semiconductor layer by an insulating film at least four times thicker than the side-wall oxide films.

According to a second aspect of the invention, there is provided a semiconductor device using a SOI substrate including a semiconductor substrate, a first insulating film formed on one surface of the semiconductor substrate and a second semiconductor layer having a heavily doped semiconductor layer and a lightly doped semiconductor layer formed integrally on the first insulating film;
wherein the second semiconductor layer has predetermined regions including an element formed region formed with a semiconductor element and an element isolating region formed to surround the element formed region;
wherein the element isolating region includes multiple trenches having a laterally closed structure reaching the first insulating film, a heavily doped region formed by thermal diffusion of the impurities of the same conduction type as the second semiconductor layer from the side walls of the multiple trenches, side-wall oxide films formed by thermal oxidation of the heavily doped layer in the multiple trenches and polysilicon filled between the side-wall oxide films;
wherein the side-wall oxide films are extended onto one of the main surfaces of the second semiconductor layer, and the polysilicon gate electrode is stacked in a predetermined region of the extended area; and
wherein the electrode of the high breakdown voltage element arranged in the neighborhood of the element isolating trench is isolated from the main surface of the second semiconductor layer by an insulating film at least four times thicker than the side-wall oxide film.

According to a third aspect of the invention, there is provided a semiconductor device using a SOI substrate including a semiconductor substrate, a first insulating film formed on one surface of the semiconductor substrate and a second semiconductor layer having a heavily doped semiconductor layer and a lightly doped semiconductor layer stacked on the first insulating film;
wherein the second semiconductor layer is configured of predetermined regions including an element formed region formed with a semiconductor element having the polysilicon gate electrode and an element isolating region formed to surround the element formed region; and
wherein the electrodes of the semiconductor elements, if wired over the element isolating region, are arranged through an insulating film having at least four times thicker than the thickest part of the insulating film arranged under the polysilicon gate electrode of the semiconductor element.

According to a fourth aspect of the invention, there is provided a semiconductor device using a SOI substrate including a semiconductor substrate, a first insulating film formed on one surface of the semiconductor substrate and a second semiconductor layer having a heavily doped semiconductor layer and a lightly doped semiconductor layer stacked on the first insulating layer;
wherein the second semiconductor layer is configured of predetermined regions including an element formed region formed with a semiconductor element and an element isolating region formed to surround the element formed region;
wherein the element isolating region includes multiple trenches having a laterally closed structure reaching the first insulating film, side-wall oxide films formed in the multiple trenches and polysilicon filled between the side-wall oxide films;
wherein the side-wall oxide films are extended onto one of the main surfaces of the second semiconductor layer;
wherein the polysilicon gate electrode is stacked in a predetermined region of the extended area; and
wherein the electrode of the high breakdown voltage element arranged in the neighborhood of the element isolating trench is formed on the second semiconductor layer through an insulating film having the field intensity of at least not more than 2 MV/cm even in the case where a high voltage is applied to the high breakdown voltage element.

According to a fifth aspect of the invention, there is provided a semiconductor device; wherein the thickness of the insulating film with the electrode metallization arranged in the neighborhood of the element isolating region is not more than six times the thickness of the side-wall oxide film.

According to a sixth aspect of the invention, there is provided a semiconductor device using a SOI substrate including a semiconductor substrate, a first insulating film formed on one surface of the semiconductor substrate and a second semiconductor layer having a heavily doped semiconductor layer and a lightly doped semiconductor layer stacked on the first insulating layer;
wherein the second semiconductor layer is configured of predetermined regions including an element formed region formed with a semiconductor element and an element isolating region formed to surround the element formed region;
wherein the element isolating region includes multiple trenches having a laterally closed structure reaching the first insulating film, side-wall oxide films formed in the multiple trenches and polysilicon filled between the side-wall oxide films;
wherein a STI (Shallow Trench Isolation) structure is configured in which a region covered with an oxide film having a substantially uniform thickness is formed on the element isolating region, and the main surface of the silicon active layer formed with the element is located at substantially the same height as the upper surface of the covered oxide films; and
wherein a polysilicon gate electrode is stacked adjacently to the STI structure, and the electrode of the high breakdown voltage element arranged in the neighborhood of the element isolating trench is isolated from the main surface of the second semiconductor layer by an insulating layer at least four times thicker than the side-wall oxide films.

According to a seventh aspect of the invention, there is provided a semiconductor device using a SOI substrate including a semiconductor substrate, a first insulating film formed on one surface of the semiconductor substrate and a second semiconductor layer having a heavily doped semiconductor layer and a lightly doped semiconductor layer stacked on the first insulating layer;
wherein the second semiconductor layer has a thickness not less than 30 µm;
wherein a high breakdown voltage element having a rated blocking voltage of not lower than 500 V and a fine MOS having the electrode length of not more than 1.0 µm coexist in a predetermined region of the second semiconductor layer; and
wherein the high breakdown voltage element has at least an inverter integrated circuit or a pre-driver integrated circuit isolated by an oxide film having an enclosed structure.

According to an eighth aspect of the invention, there is provided a method of producing a semiconductor device, comprising the steps of:
forming an oxidation resistant layer arranged in an active region of an element;
forming a deep trench in an element isolating region;
forming a heavily doped layer by self alignment in the side wall portions of the deep trench;
oxidizing the trench side walls and the silicon surface using the oxidation resistant layer as a selective oxidation mask;
forming a gate oxide film and a polysilicon gate electrode;
forming a layer insulating film; and
forming metallization of the metal electrode.

According to a ninth aspect of the invention, there is provided a method of producing a semiconductor device,
wherein the layer insulating film has a thickness not less than four times the thickness of the side-wall oxide film of the oxidized trench side walls,
According to a tenth aspect of the invention, there is provided a method of producing a semiconductor device,
wherein the layer insulating film has a thickness not more than six times the thickness of the side-wall oxide film of the oxidized trench side walls.

This invention can provide a highly reliable dielectric isolation semiconductor device high in breakdown voltage which can coexist with a fine MOS element.

The above and other objects, features and advantages will be made apparent by the detailed description taken in conjunction with the accompanying drawings.
FIG. 1 is a block diagram showing a dielectric isolation semiconductor device used as a one-chip inverter for a motor drive system according to this invention.
FIG. 2 is a cross-sectional view showing a dielectric isolation semiconductor device according to a first embodiment of the invention.
FIG. 3 is an enlarged cross-sectional view showing an element isolating region of the dielectric isolation semiconductor device according to the first embodiment of the invention.
FIGS. 4A to 4K are cross-sectional views showing the process of the production method of the dielectric isolation semiconductor device according to the first embodiment of the invention.
FIG. 5 is a cross-sectional view showing a dielectric isolation semiconductor device according to a second embodiment of the invention.
FIG. 6 is a cross-sectional view showing a dielectric isolation semiconductor device according to a third embodiment of the invention.
FIGS. 7A to 7D are cross-sectional views showing the process of the production method of the dielectric isolation semiconductor device according to the third embodiment of the invention.
FIG. 8 is a cross-sectional view showing a dielectric isolation semiconductor device according to a fourth embodiment of the invention.
FIG. 9 is a cross-sectional view showing a dielectric isolation semiconductor device according to the prior art.
FIG. 10 is a cross-sectional view of a dielectric isolation semiconductor device using a method of improvement according to the prior art.
FIGS. 11A and 11B are cross-sectional views of a dielectric isolation semiconductor device using a second method of improvement according to the prior art.

In all the diagrams for explaining the embodiments and the prior art, the same or similar component parts are designated in principle by the same or similar reference numerals, respectively, and not explained repeatedly.

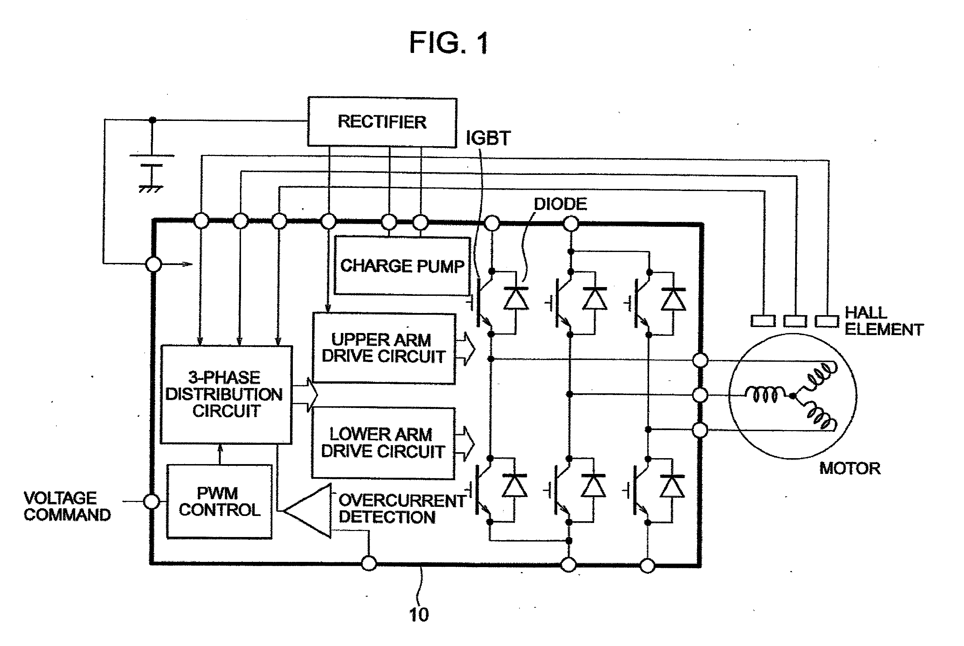

FIG. 1 shows a motor drive system using a dielectric isolation semiconductor device 10 according to an embodiment of the invention. The portion defined by a thick frame constitutes the dielectric isolation semiconductor device of a one-chip converter integrated in the same wafer. This semiconductor device is configured of six units each including an IGBT (Insulated Gate Bipolar Transistor) and a diode connected in reversely parallel to control the drive of a three-phase motor. In order to operate the IGBTs of the upper and lower arms at different potentials, a charge pump circuit is built in, a PWM control signal is generated, and the drive circuits are controlled by a distribution circuit in which the feature of this semiconductor device is that the gate drive circuits are isolated. The semiconductor device also includes several protection circuits with an overcurrent detection circuit as a typical example.

Also, in the dielectric isolation semiconductor device 10 according to this embodiment, a semiconductor, or especially, silicon is selected as a semiconductor material, and a SOI substrate advantageous for dielectric isolation is used. The SOI substrate is formed with deep trenches reaching the buried oxide film from the main surface of a silicon active layer to selectively oxidize all the side surfaces of each trench and a predetermined region of the silicon main surface. A material such as polysilicon is filled between the side-wall oxide films of the trench, and each element formed region is isolated dielectrically. After that, the gate oxide film and the gate electrode are formed, followed by forming various function regions by ion implantation. Then, contacts, electrodes and layer insulating films are formed, followed by forming electrodes again. Finally, a passivation film is formed thereby to produce the dielectric isolation semiconductor device 10. These steps are described in detail later.

### First embodiment

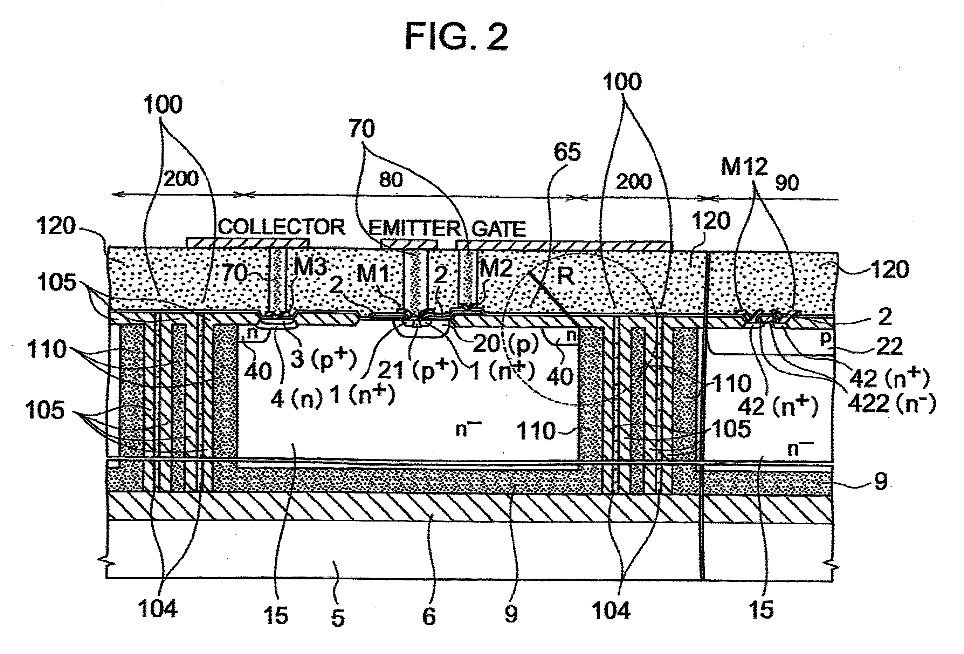

FIG. 2 is a cross-sectional view of the dielectric isolation semiconductor device according to a first embodiment of the invention. In this embodiment, an IGBT 80 is shown as a high breakdown voltage element and an nMOS 90 as a fine MOS element. The IGBT 80 and the MOS 90 are shown adjacently to each other for convenience of illustration. In the actual dielectric isolation semiconductor device, however, this arrangement is rare. The cross section of this embodiment is plotted in this manner to facilitate understanding of the invention. This embodiment also shows a case in which only one element is surrounded by element isolating regions 200 having a dielectric isolation structure, while the remaining element formed regions are not shown. The substrate has a SOI structure including a n-type silicon active layer, a buried silicon oxide film 6 and a silicon support substrate 5. A n-type silicon active layer 15 is configured of a lightly doped n⁻⁻-type silicon layer and a heavily n⁺ doped silicon layer on the bottom surface of the lightly doped n⁻⁻-type silicon layer. Substantially vertical trenches 100 are formed extending from the main surface of the n-type silicon active layer 15 to the silicon oxide film 6. These trenches form a closed loop in plan view and have a function to isolate the inside and outside thereof. An n⁺ heavily doped layer 110 is formed along each side wall of the isolating trench 100. Also, silicon oxide films 105 having a substantially uniform thickness are formed adjacently to the n⁺ heavily doped layers 110 on the side walls of each isolating trench 100. The gap area of the isolating trench 100 sandwiched between the silicon oxide films 105 is filled with a polysilicon layer 104 to form an element isolating region 200. The silicon oxide film 105 formed on the side walls of each isolating trench 100 extends on the main surface of the n-type silicon active layer 15 and covers the upper surface of the element isolating region 200. This embodiment has a double structure formed with the isolating trenches 100 at predetermined intervals. The emitter, gate and collector regions are formed to operate as an IGBT element within the silicon active layer 15 surrounded by the element isolating region 200. The emitter is an n⁺-type silicon layer 1. A p-type silicon layer is formed as a channel region around the n⁺-type silicon layer 1. The p⁺-type silicon region 21 is formed on the silicon surface of the channel region 20 thereby to form an emitter electrode M1 connected in ohmic contact with the n⁺-type silicon layer 1 and the p⁺-type silicon layer 21. A gate electrode 2 including a polysilicon layer is formed through a gate oxide film on the surface of the p⁺-type channel region 20. Further, a collector region is formed in predetermined spaced and opposed relation to the emitter. The collector region is configured with a p⁺-type collector layer 3 and an n-type buffer layer 4 for controlling the hole implantation amount from the p⁺-type collector layer 3. Furthermore, an n-type layer 40 comparatively low in impurity concentration and large in diffusion depth is formed to relax the electric field.

The element formed on the right side of the region of the IGBT 80, on the other hand, is an nMOS 90 with a small length of the gate electrode 2. A source-drain region 42 and a lightly doped source-drain region 422 of an n⁺-type silicon layer are formed on both sides of the fine gate electrode 2 with the p-type silicon layer as a p-type channel layer 22. Further, the source and drain electrodes M12 are formed as metal electrodes in ohmic contact with the source-drain region 42.

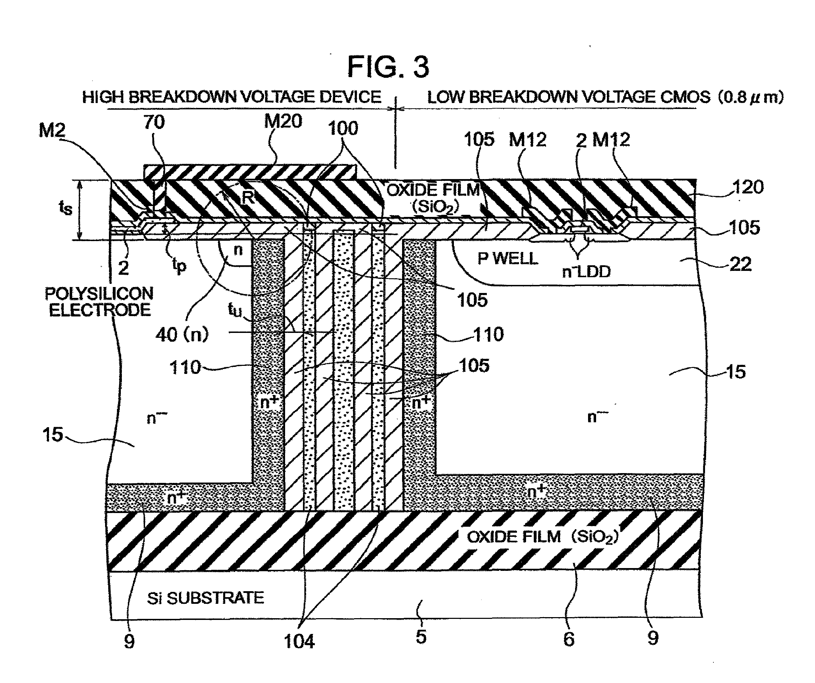

FIG. 3 is an enlarged view of the neighborhood of the element isolating region 200. The oxide film 105 of the side walls of the isolating trench extends also on the silicon surface, and the polysilicon gate electrode 2 is formed on the oxide film 105. As a result, the thickness of the oxide film under the gate electrode is substantially equal to the thickness tu of the oxide film formed on the side walls of the isolating trench. In processing the polysilicon gate electrode 2, the absolute misalignment (the amount indicated by tu in the drawing) of the surface on which the polysilicon gate electrode 2 is arranged poses the problem. According to this embodiment, the value tp corresponds to the thickness about one half of the thickness of the oxide film 105 on the side walls of the isolating trench. This point is explained in more detail later with reference to the production method according to this embodiment. The oxide film 105 on the side walls of the isolating trench determines the breakdown voltage at which the collector region of the n⁺ heavily doped layer 110 and the silicon active layer 15 in the outer n-type region are electrically isolated from each other, and advantageously formed as thick as possible to secure a high breakdown voltage. According to this embodiment, the silicon active layer 15 in the collector region is isolated by the double isolating trenches 100, and therefore, the isolation oxide film is four times as thick as tu. In describing using specific numerical values, the tu value is preferably not less than 0.8 µm to realize the dielectric isolation of 500 V. In this case, the value tp is approximately 0.4 µm, and considering the focal depth of the light for photolithography, this value generally enabling processing as fine as 0.8 µm. In this way, this embodiment provides a structure in which the fine processing of 0.8 µm and the element isolation breakdown voltage of 500 V can be both realized.

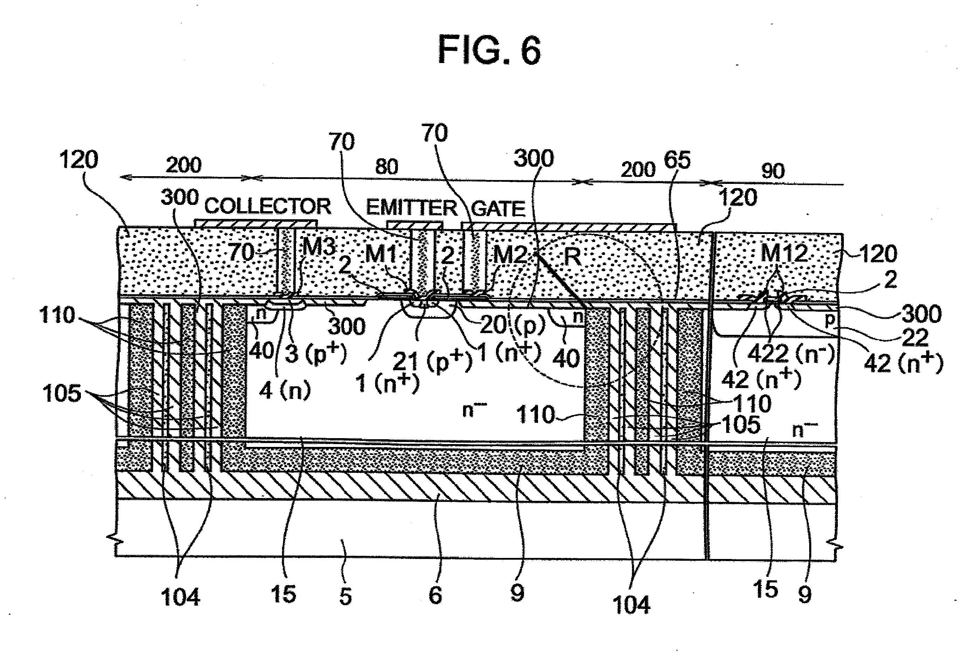

Further, considering the operation of the IGBT element 80 of this embodiment, the n⁺-type doped layer 110 in the collector area has the highest potential of the element, and the gate electrode 2 operates at a potential near to the ground potential. As a result, some countermeasure must be taken to prevent the dielectric breakdown by a high voltage applied between the gate electrode and the n⁺-type doped layer 110 of the n⁺-type collector region. According to this embodiment, the polysilicon constituting the gate electrode is not extended as it is out of the IGBT 80. Instead, the polysilicon is provisionally connected in ohmic contact with the metal gate electrode M2, and further connected to the electrode metallization M20 through the electrode member 70, so that this electrode metallization M20 is arranged on the element isolating region 200 through the thick silicon oxide film. Especially, it is essential that the region in the circle having a radius R extending from the upper surface end of the n⁺-type collector region in FIG. 6 is configured in such a manner as not to include the gate electrode 2 and any electrode of the metallization leading from the gate electrode 2. Further, this circle is required to have a radius at least four times as large as the value tu to secure the dielectric breakdown. Also, though not clearly shown in the drawings, it is essential not to include the emitter electrode metallization, the collector electrode metallization, etc. as well as the gate electrode 2.

### Second embodiment

### Production method according to the first mode of carrying out the invention

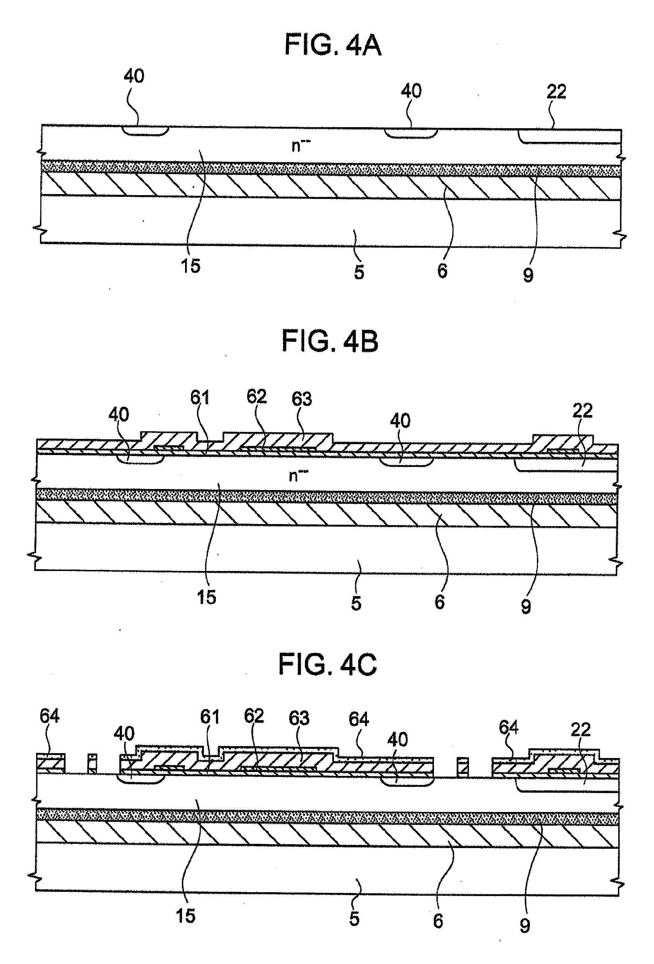

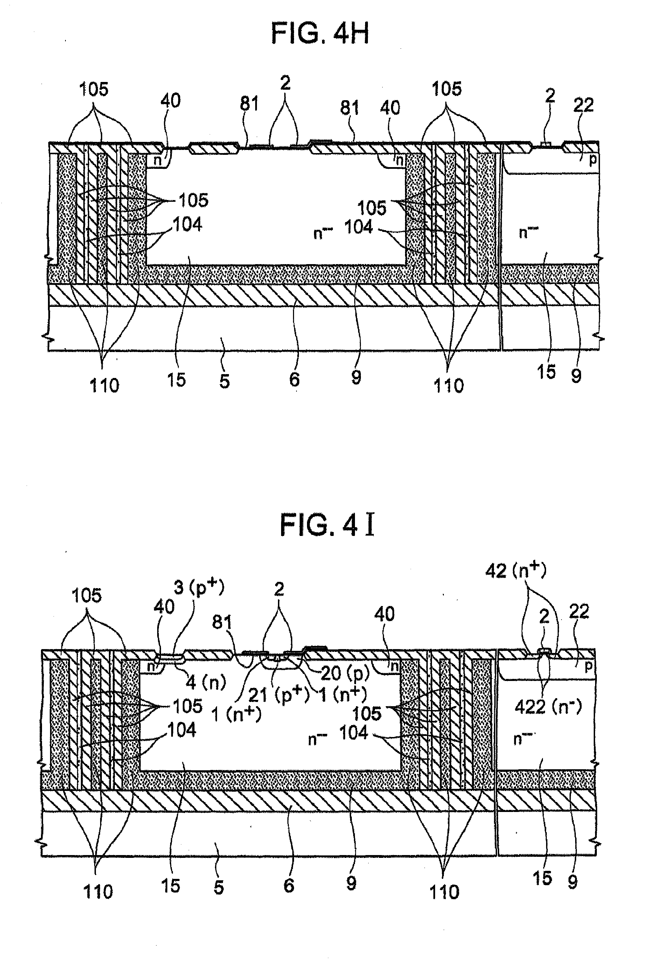

FIGS. 4A to 4K are cross-sectional views showing steps of the production method of the dielectric isolation semiconductor device according to the first mode of carrying out of the invention.

In FIG. 4A, a SOI substrate is prepared in which a n-type silicon active layer 15 is stacked with a heavily doped n⁺-type silicon layer 9 on one surface of the silicon support substrate 5 through a silicon oxide film 6. An n-type electric field relaxation layer 40 and a p-type channel layer 22 of the fine MOS are selectively formed by the drive method using heat treatment and ion implantation in a predetermined region of the n-type silicon active layer 15.

In FIG. 4B, a thin (preferably in the range of 500 Ǻ to 1500 Ǻ) thermal oxide film 61 is formed on the main surface of the n--type silicon active layer 15, and a silicon nitride film 62 is formed by CVD on the thermal oxide film 61. Then, a silicon nitride film 62 is left selectively by dry etching only in the portion constituting an active region. Next, an oxide film 63 is formed by CVD over the whole main surface of the n⁻-type silicon active layer 15.

In FIG. 4C, an opening is formed in the CVD oxide film 63 and the underlying thermal oxide film 61 by the selective dry etching technique using a normal photoresist film 64.

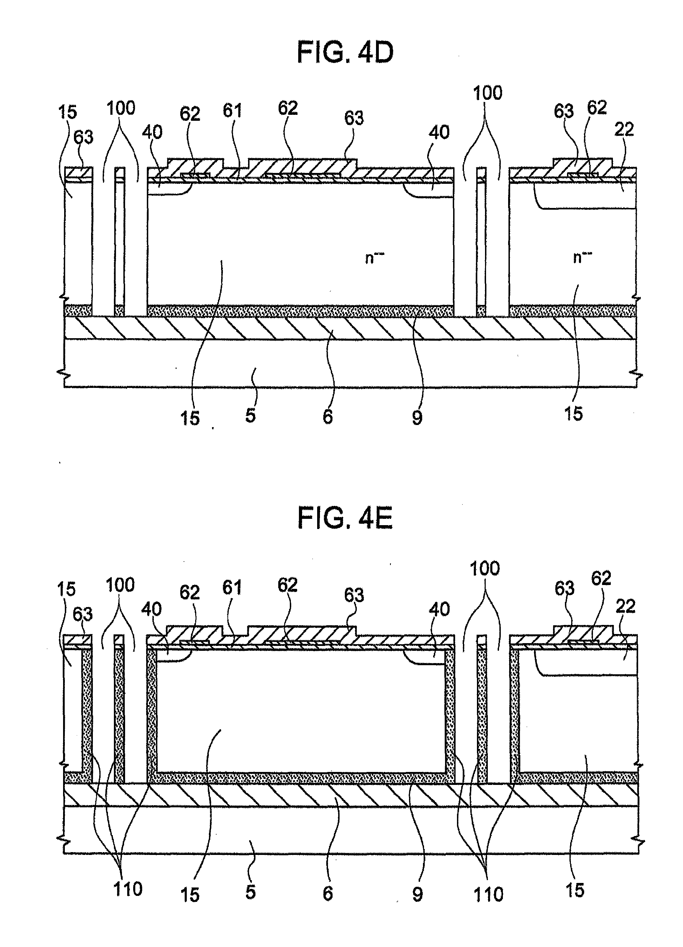

In FIG. 4D, the trench of the silicon is dug using a dry etching machine for generating a high-density plasma with the same resist film as a mask. In the process, a processing is required to form the vertical trenches 100 in such a shape as to reach the buried silicon oxide film. The cross section of the trench is preferably vertical or has what is called the normal taper shape slightly reduced in thickness inward. According to this embodiment, the trench width is approximately 2 µm with a depth of 20 µm to 80 µm.

After the processing, the resist 64 of the mask is removed.

In FIG. 4E, n-type impurities such as antimony (Sb), arsenic or phosphor are diffused with the CVD oxide film 63 as a mask by the gas-phase diffusion method only in the n--type silicon active layer 15 exposed to the side surface of the trench 100 thereby to form a n⁺-type heavily doped layer 110.

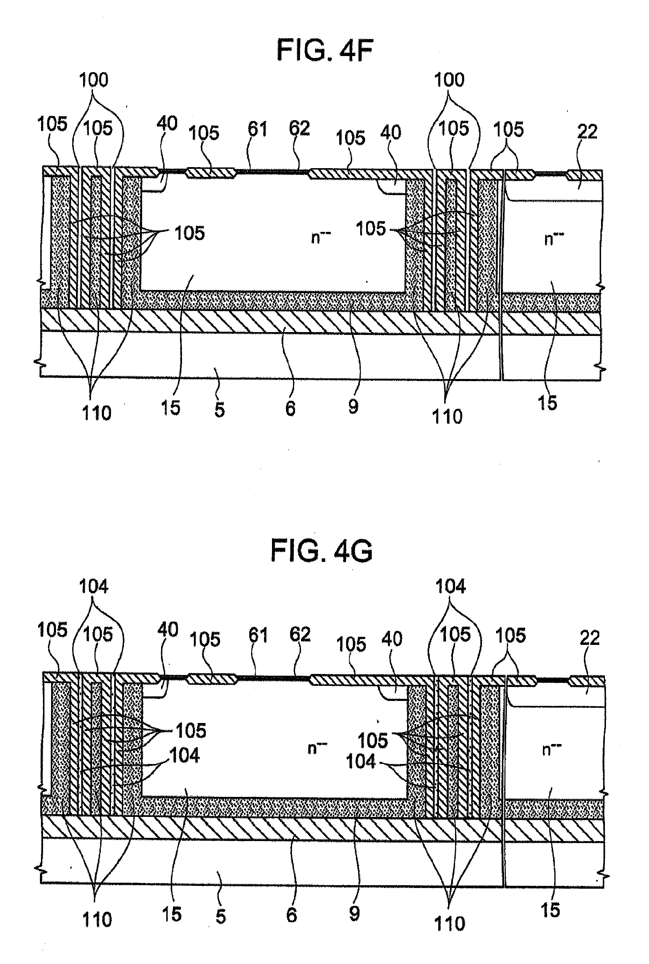

In FIG. 4F, the main surface of the n-type silicon active layer 15 is exposed by removing the CVD oxide film 63 and the thermal oxide film 61. After that, a heat treatment is conducted in an oxide atmosphere, so that a silicon oxide film 105 of a substantially uniform thickness is formed on the exposed silicon surface of the n--type silicon active layer 15 and the side walls of the trench 100. In the process, since the main surface of the silicon active layer is partially covered with the silicon nitride film 62, the silicon is not oxidized in the particular part. The production method described above has an advantage that since the oxide films 105 are formed on the trench side surfaces by the thermal oxidation, the trench width is as small as not more than 2 µm, and the oxide film 105 can be formed in uniform thickness on the side surfaces of the trench 100 exposed even in the depth of 80 µm. Furthermore, the oxidation of the silicon surface grows upward and downward substantially at the same rate from the initial surface position. On the other hand, the region covered by the silicon nitride film 62 is not oxidized and therefore maintains the initial surface position. In this method of forming the oxide film, the step between the silicon main surface and the upper surface of the oxide film is only one half of the thickness of the oxide film. This method, therefore, is very effective to reduce the misalignment.

In FIG. 4G, a gap exists between the oxide films 105 formed on the side surface of the trench 100 and this gap is filled with the polysilicon formed by the CVD method. In the case where the width of the trench 100 is small, on the other hand, the opposed oxide films 105 would come into contact with each other in the neighborhood of the trench center during the growing process of the oxide films on the opposed side surfaces of the trench in the step shown in FIG. 4F, and consequently, a large compressive stress is exerted on the silicon side surface at the time of contacting, resulting in dislocations. Therefore, adequate care must be taken about the trench width and the oxidation amount of the side surfaces. As disclosed in this embodiment, FIG. 4F shows a superior method in which the gap left in the trench 100 is filled with polysilicon 104 as shown in the step of FIG. 4G to avoid the stress described above. Next, the CMP (Chemical Mechanical Polishing) process is used to remove the polysilicon 104 formed on the oxide film 105 on the main surface of the n-type silicon active layer. As a result, the production of the dielectric-isolated substrate leaving only the polysilicon layer 104 filled in the gap of the trench 100 is completed.

In FIG. 4H, a gate oxide film 81 is formed and a polysilicon film 2 is formed thereon by CVD. After that, the polysilicon film 2 is machined to a predetermined dimension and shape. In the process, the polysilicon film 2 is formed on a surface with few steps, and therefore, even in the case where the focal depth is reduced by use of the i ray having short wavelength, the steps are controlled to smaller than the focal depth, so that it is applicable to the general fine processing using the i ray for the exposure, According to this embodiment, the minimum width of the polysilicon (gate electrode) is 0.8 µm.

In FIG. 4l, each function region necessary for the high breakdown voltage element such as the IGBT 80 requires a deeper junction as compared with the fine MOS element. For this reason, the p-type channel layer 20 and the n-type buffer layer 4 of the IGBT 80 are formed first. After that, the source-drain region 422, the source-drain region 42, and further, the emitter layer 1 and the collector layer 3 of the IGBT 80 having an LDD structure using side walls constituted with gate electrode oxide films which is the standard structure for the 0.8 µm MOS, are formed by the ion implantation technique.

In this embodiment, a production method is explained in which, the gate oxide film and the polysilicon gate electrode corresponding to the IGBT 80 of the high breakdown voltage element, and the gate oxide film and the polysilicon electrode of the 0.8-µm nMOS 90, are formed of the same material in the same process. Nevertheless, a production method is also available in which the gate oxidation step and the step of forming the polysilicon gate electrode are executed separately from each other to differentiate the thickness of the gate oxide film between the IGBT and the 0.8-µm MOS.

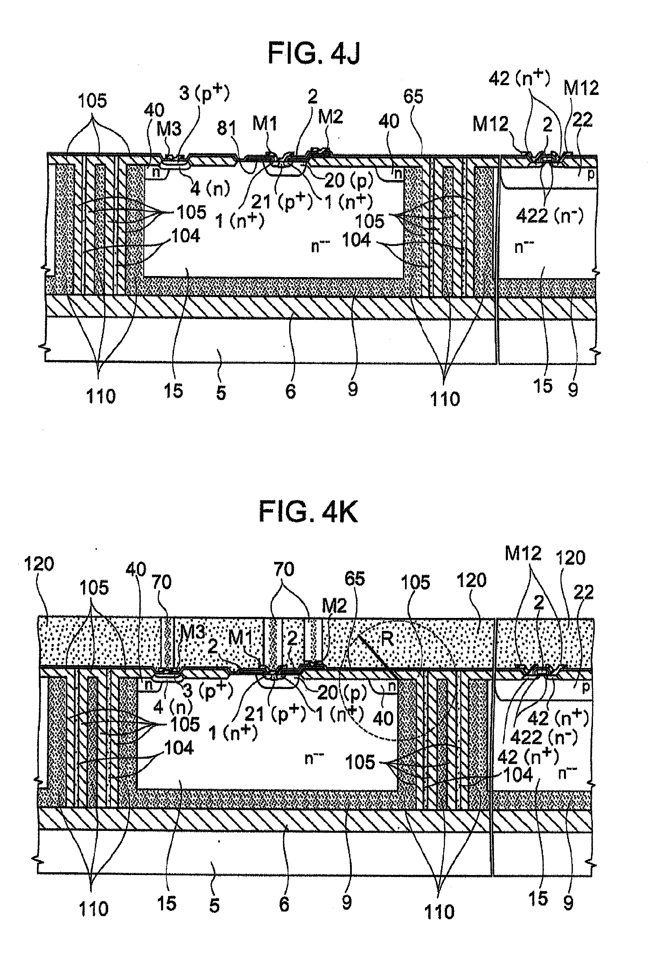

In FIG. 4J, a first layer insulating film 65 of a CVD oxide film or a CVD oxide film (called the BPSP film or the PSG film) containing boron or phosphorus which reflows by a certain degree of heat treatment is formed, and further by forming contact holes and depositing the first Al electrode by sputtering, and then by photolithogpraphy, the emitter electrode M1, the gate electrode M2, the collector electrode M3 and the source-drain electrode M12 of the fine MOS is formed.

In FIG. 4K, a CVD oxide film is formed as a second layer insulating film 120 at least four times as thick as the trench side-wall oxide films 105 to permit the voltage insulation. Next, a deep connection hole is formed in the CVD oxide film, and a metal film of tungsten or the like is buried in the connection hole using the CVD or CMP process thereby to form buried plugs 70. In the process, a method may be additionally employed in which the CVD oxide film is formed into a substantially flat surface in the wafer plane by the CMP process.

Next, a second electrode is formed by sputtering, and processed into the emitter, collector, gate, source and drain electrodes, and the semiconductor device according to the first embodiment shown in FIG. 2 is completed. In the embodiment shown in FIG. 2, a final passivation film such as a silicon nitride film is omitted. This point is similarly described with the omission in the other embodiments.

### Third embodiment

Next, the dielectric isolation semiconductor device according to a second mode of carrying out the invention is explained.

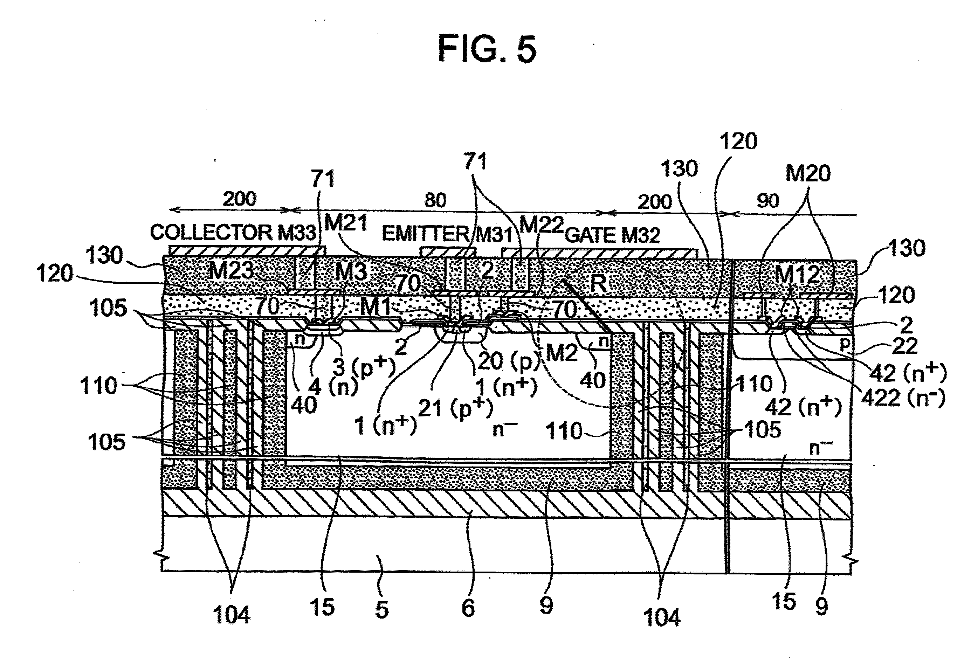

FIG. 5 is a cross-sectional view of the dielectric isolation semiconductor device according to this mode of carrying out the invention. In the dielectric isolation semiconductor device according to this mode of carrying out the invention, a source electrode M31 and a gate electrode M32 required to be dielectrically isolated by a blocking voltage not lower than the rated voltage from the heavily doped layer 110 of the n⁺-type collector region of the IGBT 80 being a high breakdown voltage element are formed through a two-layer structure of the second layer insulating film 120 and the third layer insulating film 130. Specifically, unlike in the first mode of carrying out the invention shown in FIG. 2 in which the lower electrode and the uppermost electrode are isolated through the single layer of the second layer insulating film 120, this embodiment has the two-layer structure of the second layer insulating film 120 and the third layer insulating film 130. The lowest electrode is connected to the uppermost electrode 120 through the first plugs 70 and the second plugs 71. According to this embodiment, the depth of the contact hole for connecting the electrodes is so shallow that the process of forming the plug electrode filled in the connection hole is simplified, thereby realizing a stable production, a higher production yield and a lower process cost. Further, the layer insulating film can be formed easily in a larger thickness for a further improved dielectric breakdown voltage.

### Fourth embodiment

Now, a dielectric isolation semiconductor device according to a third mode of carrying out the invention is explained.

FIG. 6 is a cross-sectional view of the dielectric isolation semiconductor device according to this embodiment of the invention. The feature of the dielectric isolation semiconductor device according to this embodiment is that an element isolation structure generally called STI (Shallow Trench Isolation) is employed. STI is represented by a structure 300 in which the n-type silicon active layer between the element regions is etched from the main surface thereof and the CVD oxide film is buried in the etched part. The isolation trench 100 is formed under the element isolating region 300 formed on the main surface of the n-type silicon active layer, and filled with the side-wall oxide film 105 and the polysilicon 104 to make up the dielectric isolating region. In the structure of STI 300, the main surface of the n-type silicon and the upper surface of the CVD oxide film of the STI 300 are located substantially at the same position. Therefore, the polysilicon making up the gate electrode is formed substantially in the absence of a step. Thus, the problem of the focal depth is not posed in the processing. Specifically, unlike in the other embodiments and the conventional technique of photolithography, the problem is not posed which otherwise might have an adverse effect on processing the gate electrode, and therefore, a fine MOS can be easily employed.

The horizontal element isolation from the adjacent regions can be secured with the thickness tu of the oxide film 105 formed on the side walls of the isolation trench. With regard to the insulation characteristic between the source electrode, the gate electrode and the collector, the thickness of the STI 300 and the second layer insulating film 120 is required to be selected in such a manner as to secure up to a predetermined thickness in terms of the radius R of a circle described in FIG. 6. In this way, the feature of this embodiment lies in that the electrical insulation in the horizontal and vertical directions can be set independently of each other without affecting each other.

### Fifth embodiment

### Production method for carrying out second mode of invention

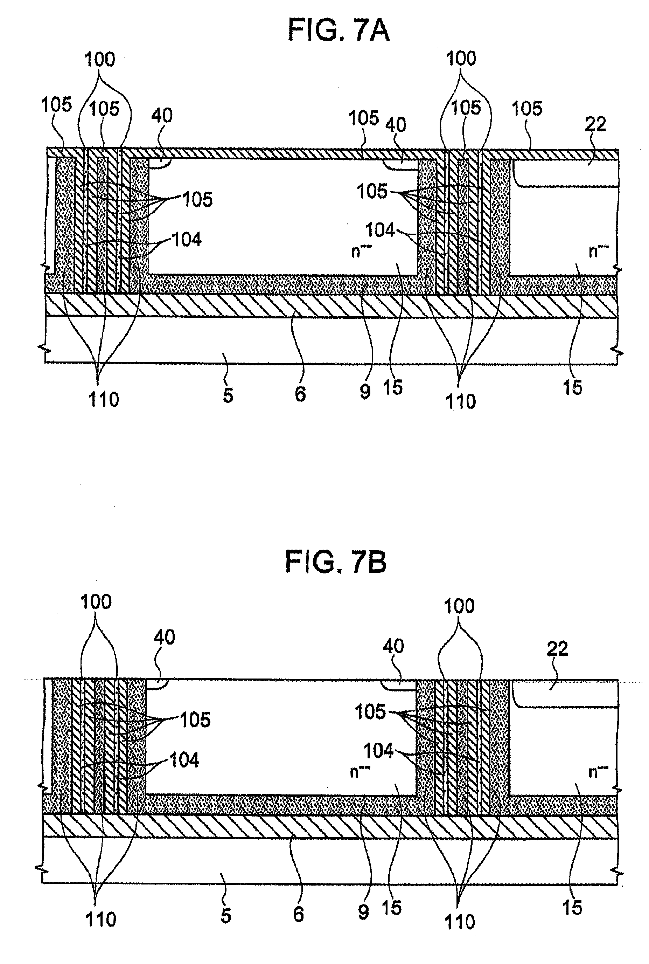

FIGS. 7A to 7D are cross-sectional views showing steps of the production method of a dielectric isolation semiconductor device according to a third mode of carrying out the invention.

In FIG. 7A, the process is started with the SOI substrate, and an n-type electric field relaxation layer 40 and a p-type channel layer 22 of the fine MOS are formed selectively by the ion implantation and the drive method using heat treatment in a predetermined region of the n-type silicon active layer 15. After that, a thermal oxide film and a CVD oxide film are formed. Further, photoresist is coated to form a pattern, and using this as a mask, the oxide films and the silicon are dry etched to form an isolation trench. After forming the isolation trench, the resist of the mask is removed, and then, using the CVD oxide film as a mask, n-type impurities such as antimony (Sb), arsenic or phosphor are diffused by the gas-phase diffusion method only in the n⁻-type silicon active layer 15 exposed to the side surface of the trench 100 thereby to form each of the n⁺-type heavily doped layers 110. Next, the CVD oxide film and the thermal oxide film are removed to expose the main surface of the silicon, after which a silicon oxide film 105 of a substantially uniform thickness is formed on the surface of the n⁻⁻-type silicon active layer 15 and the side walls of each trench 100. Next, polysilicon 104 is filled in the space of the isolation trench by depositing the polysilicon, followed by polishing with the CMP process.

In FIG. 7B, the thermal oxide film 105 and the polysilicon 104 formed on the main surface of the n-type silicon active layer are removed by polishing with the CMP process thereby to expose the surface of the n⁻-type silicon active layer 15 uniformly.

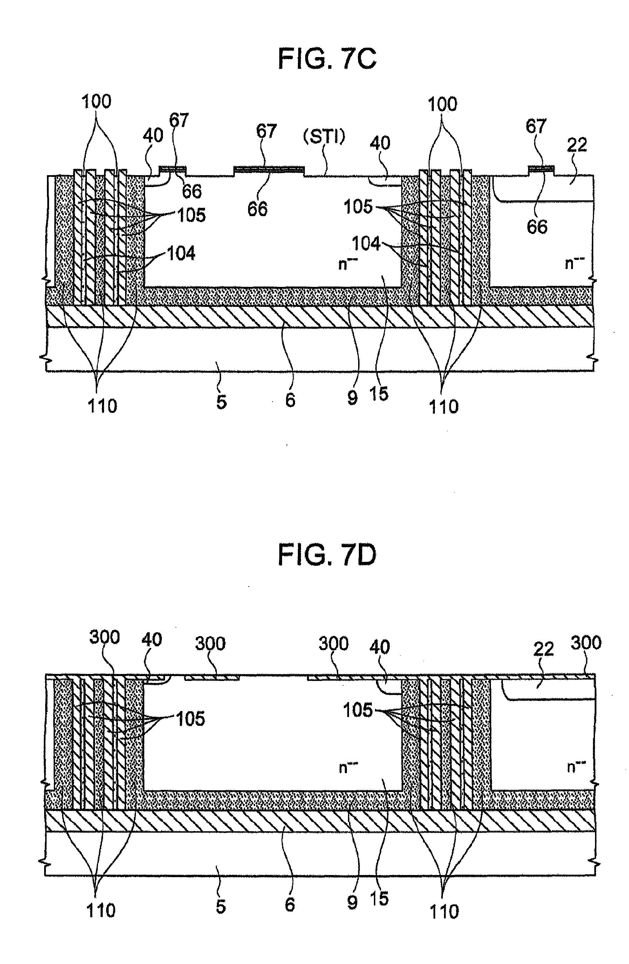

In FIG. 7C, an oxide film 66 and a silicon nitride film 67 are formed on the main surface of the n-type silicon active layer 15. After that, the stacked film is left only in a predetermined region. Next, using the silicon nitride film 67 as a mask, the silicon is dry etched. In the process, the silicon is desirably etched by approximately 0.3 µm to 0.5 µm.

In FIG. 7D, a high-quality oxide film is formed using the chemical reaction in a high-density plasma environment in a shallow depression region formed selectively on the main surface of the n-type silicon active layer. Next, the oxide film is polished by the CMP process, and the etched silicon portion is filled with an oxide film thereby to form the element isolation structure of the STI 300. In the CMP process, the silicon nitride film 67 formed in the process shown in FIG. 7C is used as an etching stopper. As a result, the STI element isolation structure and the underlying dielectric isolation substrate isolated by the deep isolation trenches are accomplished. After that, each function area of the IGBT and the fine MOS is formed. Then, through the process of forming the electrodes and the layer insulating films, the semiconductor device is completed.

### Sixth embodiment

Next, the dielectric isolation semiconductor device according to a fourth mode of carrying out the invention is explained

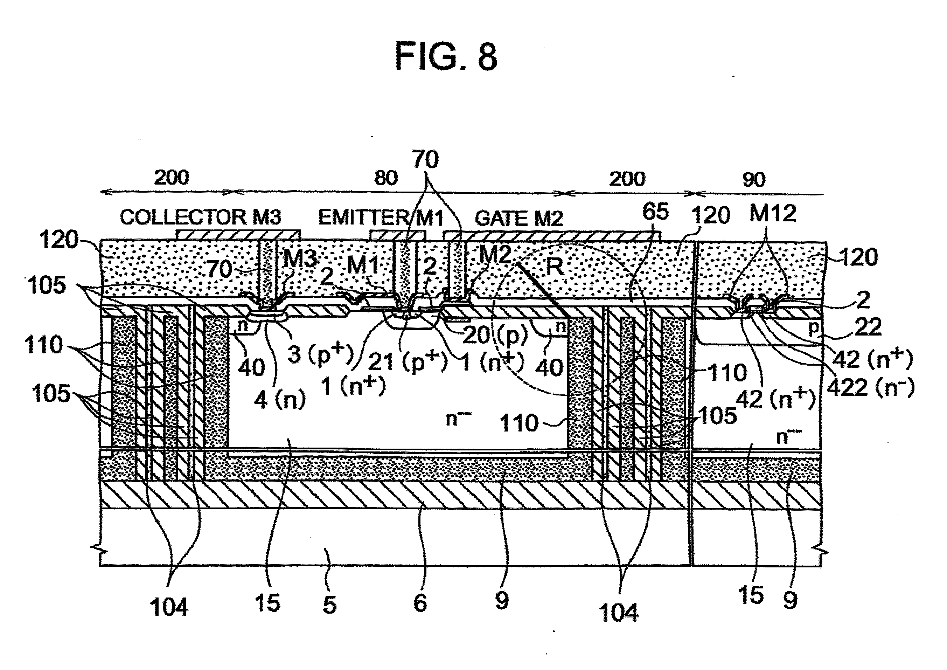

FIG. 8 is a cross-sectional view of the dielectric isolation semiconductor device according to this embodiment of the invention. The feature of this embodiment of the invention lies in that the emitter electrode M1 and the collector electrode M3 of the IGBT are formed to extend approaching each other on the first layer insulating film 65. In this configuration, the potential gradient in the silicon is relaxed so that the field concentration is avoided by the approach between the emitter potential and the collector potential. As a result, performance of the IGBT is further improved, i.e. the breakdown voltage thereof can be further increased, or the loss thereof is reduced, and so forth. According to this embodiment, the emitter and collector electrodes are extended, so that the voltage is applied between the extended region and the underlying silicon surface. Therefore, the first layer insulating film is desirably formed in a large thickness.

The invention the invention is not limited to these embodiments and of course modifiable variously without departing from the scope of the invention. For example, in each embodiment described above, only the typical elements such as the IGBT and the fine nMOS are described. The dielectric isolation structure shown in these embodiments, however, is of course applicable also to other elements such as high breakdown voltage nMOS, high breakdown voltage pMOS and such elements as resistors, a diodes and bipolar elements. According to this invention, a highly reliable dielectric isolation semiconductor device high in breakdown voltage and a production method thereof can be realized. Thus, this invention is applicable also to a dielectric isolation semiconductor device for controlling a motor in which high breakdown elements, large-current output circuits, medium and low breakdown voltage logic circuits are integrated with each other.

## Claims

1. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein an element formed area (80, 90) which includes a semiconductor element is formed in a predetermined region of the second semiconductor layer;
wherein an element isolating region (200) is formed to surround each of the element formed areas (80, 90);
wherein the element isolating region (200) includes multiple trenches (100) having a laterally closed structure reaching the first insulating film (6), side-wall oxide films (105) formed in the multiple trenches (100) and polysilicon (104) filled between the side-wall oxide films (105);
wherein the side-wall oxide films (105) extend onto one of main surfaces of the second semiconductor layer, and a polysilicon gate electrode (2) is stacked in a predetermined area of each extension; and
wherein the electrode (M2, M20) of a high breakdown voltage element arranged in the neighborhood of the element isolation trench (100) is isolated from the main surface of the second semiconductor layer by an insulating film (120) at least four times thicker than a thickness (tu) of the side-wall oxide films (105).

2. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein an element formed area (80, 90) which includes a semiconductor element is formed in a predetermined region of the second semiconductor layer;
wherein an element isolating region (200) is formed to surround each of the element formed areas (80, 90);
wherein the element isolating region (200) includes multiple trenches having a laterally closed structure reaching the first insulating film (6), a heavily doped layer (110) formed by thermal diffusion of impurities of the same conduction type as the second semiconductor layer from the side walls of the multiple trenches (100), side-wall oxide films (105) formed by thermal oxidation of the heavily doped layer (110) formed on the side walls of the multiple trenches (100), and polysilicon (104) filled between the side-wall oxide films (105);
wherein the side-wall oxide films (105) extend onto one of main surfaces of the second semiconductor layer, and a polysilicon gate electrode (2) is stacked in a predetermined area of each extension; and
wherein the electrode (M2, M20) of a high breakdown voltage element arranged in the neighborhood of the element isolation trench (100) is isolated from the main surface of the second semiconductor layer by an insulating film (120) at least four times thicker than a thickness (tu) of the side-wall oxide films (105).

3. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein an element formed area (80, 90) which includes a semiconductor element is formed in a predetermined region of the second semiconductor layer;
wherein an element isolating region (200) is formed to surround each of the element formed areas (80, 90); and
wherein the electrodes of the semiconductor elements, whenever wired over the element isolating region (200), are arranged through an insulating film (120) at least four times thicker than a thickest part of an insulating film arranged under a polysilicon gate electrode (2) of the semiconductor elements.

4. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein an element formed area (80, 90) which includes a semiconductor element is formed in a predetermined region of the second semiconductor layer;
wherein an element isolating region (200) is formed to surround each of the element formed areas (80, 90);
wherein the element isolating region includes multiple trenches (100) having a laterally closed structure reaching the first insulating film (6), side-wall oxide films (105) formed in the multiple trenches (100) and polysilicon (104) filled between the side-wall oxide films (105);
wherein the side-wall oxide films (105) extend onto one of main surfaces of the second semiconductor layer, and a polysilicon gate electrode (2) is stacked in a predetermined area of the extension; and
wherein electrodes of the high breakdown voltage elements (M2, M20) arranged in the neighborhood of the element isolation trench (100) are formed on the second semiconductor layer through an insulating film of such a thickness as to secure a field intensity of at least not more than 2 MV/cm against a high voltage which is applied to the high breakdown voltage elements.

5. The semiconductor device according to any one of Claims 1 to 4;
wherein thickness of an insulating film (120) on which electrode metallization is arranged in the neighborhood of the element isolating region (200) is not more than six times of a thickness (tu) of the side-wall oxide films (105).

6. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein an element formed area (80, 90) which includes a semiconductor element is formed in a predetermined region of the second semiconductor layer;
wherein an element isolating region (200) is formed to surround each of the element formed areas (80, 90);
wherein the element isolating region (200) includes multiple trenches (100) having a laterally closed a structure reaching the first insulating film (6), side-wall oxide films (105) formed in the multiple trenches (100) and polysilicon (104) filled between the side-wall oxide films (105);
wherein the semiconductor device has a STI structure in which a region is formed covering the element isolating region (200) with an oxide film of a substantially uniform thickness and in which a main surface of a silicon active layer constituting the element is located at substantially the same level as a upper surface of the covering oxide film;
wherein a polysilicon gate electrode is stacked adjacently to the STI structure; and
wherein the electrode (M2, M20) of a high breakdown voltage element arranged in the neighborhood of the element isolation trench (100) is isolated from the main surface of the second semiconductor layer by an insulating film (120) at least four times thicker than a thickness (tu) of the side-wall oxide films (105).

7. A semiconductor device using a SOI substrate comprising:
a semiconductor substrate (5);
a first insulating film (6) formed on one surface of the semiconductor substrate (5); and
a second semiconductor layer having a heavily doped semiconductor layer (9) and a lightly doped semiconductor layer (15) formed integrally on the first insulating layer;
wherein the second semiconductor layer has a thickness not less than 30 µm, and a high breakdown voltage element having a rated blocking voltage of not lower than 500 V and a fine MOS having a gate electrode length of not more than 1.0 µm coexist in a predetermined region of the second semiconductor layer; and
wherein the high breakdown voltage element has at least selected one of an inverter integrated circuit or a pre-driver integrated circuit isolated by an oxide film having an enclosed structure.

8. A method of producing a semiconductor device, comprising the steps of:
forming an oxidation resistant layer (62) in an active layer of an element;
forming a deep trench (100) in an element isolating region (200);
forming a heavily doped layer (110) by self alignment in the side wall portions of the deep trench (100);
oxidizing the trench side walls and a silicon surface using the oxidation resistant layer (62) as a selective oxidation mask;
forming a gate oxide film (81) and a polysilicon gate electrode (2);
forming a layer insulating film (120); and
forming wiring of metal electrodes.

9. The method of producing a semiconductor device according to Claim 8,
wherein the layer insulating film (120) has a thickness not less than four times of a thickness of the side-wall oxide films (105) of the oxidized trench side walls.

10. The method of producing a semiconductor device according to Claim 9,
wherein the layer insulating film (120) has a thickness not more than six times of the thickness of the side-wall oxide films (105) of the oxidized trench side walls.
